# EUROPÄISCHE PATENTSCHRIFT

(11) **EP 3 491 708 B1**
(45) Veröffentlichungstag und Bekanntmachung des Hinweises auf die Patenterteilung: **09.08.2023**
(21) Anmeldenummer: 17735397.6
(22) Anmeldetag: 29.06.2017
(51) Int. Cl.: H02H 3/50, G01R 29/16, G01R 29/18, H02H 7/12, H02H 7/125

(54) **ANTRIEBSSYSTEM MIT EINER ANORDNUNG ZUR ERKENNUNG VON NETZFEHLERN UND VERFAHREN ZUR ERKENNUNG VON NETZFEHLERN**
DRIVE SYSTEM HAVING AN ARRANGEMENT FOR DETECTING GRID FAULTS AND METHOD FOR DETECTING GRID FAULTS
SYSTÈME D'ENTRAÎNEMENT COMPORTANT UN DISPOSITIF DE DÉTECTION DE PANNES DE RÉSEAU ET PROCÉDÉ DE DÉTECTION DE PANNES DE RÉSEAU

(30) Priorität: 28.07.2016 DE 102016009159
(43) Veröffentlichungstag der Anmeldung: 05.06.2019
(73) Patentinhaber: SEW-Eurodrive GmbH & Co, 76646 Bruchsal (DE)
(72) Erfinder: KOLLAR, Hans Jürgen, 76646 Bruchsal (DE); STARK, Marcel, 74909 Meckesheim (DE); HERZOG, Ralf, 76676 Graben-Neudorf (DE)
(86) Internationale Anmeldenummer: PCT/EP2017/025188
(87) Internationale Veröffentlichungsnummer: WO 2018/019428

(56) Entgegenhaltungen:
- EP-A2- 0 280 382
- DE-A1- 3 117 284
- DE-C1- 19 713 475
- GB-A- 2 059 078

## Beschreibung

Die Erfindung betrifft ein Antriebssystem mit einer Anordnung zur Erkennung von Netzfehlern und ein Verfahren zur Erkennung von Netzfehlern.

Es ist allgemein bekannt, dass ein Antriebssystem aus einem Drehspannungsnetz als Wechselspannungsversorgungsnetz versorgbar ist.

**Aus der** DE 197 13 475 C1 **ist ein Verfahren zur Überwachung von Phasenfehlern eines Dreiphasen-Wechselstromnetzes bekannt.**

**Aus der** DE 31 17 284 A1 **ist eine Schaltungsanordnung zur Überwachung eines symmetrischen Dreiphasen-Wechselstroms bekannt.**

**Aus der** EP 0 280 382 A2 **ist eine Wechselrichtersteuermethode bekannt.**

**Aus der** GB 2 059 078 A **ist eine Verbesserung bezüglich einer Phasensequenzindikation bekannt.**

Der Erfindung liegt daher die Aufgabe zugrunde, die Betriebssicherheit bei einer Anlage mit Antriebssystem zu verbessern.

Erfindungsgemäß wird die Aufgabe durch ein Antriebssystem mit einer Anordnung zur Erkennung von Netzfehlern mit **den in Anspruch 1** und durch ein Verfahren zur Erkennung von Netzfehlern mit den in Anspruch **8** angegebenen Merkmalen gelöst. Wichtige Merkmale der Erfindung bei dem Antriebssystem mit einer Anordnung zur Erkennung von Netzfehlern sind, dass das Antriebssystem einen aus einem Wechselspannungsversorgungnetz insbesondere über ein Netzfilter versorgten Gleichrichter eines Umrichters aufweist,
wobei aus dem gleichspannungsseitigen Anschluss des Gleichrichters der gleichspannungsseitige Anschluss eines Wechselrichters des Umrichters versorgt ist, wobei der Wechselrichter einen Elektromotor speist,
wobei jeder Phasenspannung des Wechselspannungsversorgungsnetzes ein Komparator zugeordnet ist,
wobei die Ausgangssignale der Komparatoren einem logischen Verknüpfungsmittel zugeführt werden, dessen Ausgangssignal galvanisch getrennt einer Auswerteeinheit zugeführt wird,
wobei der jeweilige Komparator ein Ausgangssignal erzeugt, das zu der Nulldurchgängen der jeweiligen Phasenspannung des Wechselspannungsversorgungsnetzes synchrone Pulse aufweist und dem logischen Verknüpfungsmittel zugeführt wird,
wobei das Ausgangssignal des logischen Verknüpfungsmittels dem Rücksetzeingang eines proportional zu einem Taktsignal hochzählenden Zählers der Auswerteeinheit zugeführt wird,
wobei der beim jeweiligen Rücksetzen des Zählers vorhandene Zählerstand in einem Speicher, insbesondere Ringspeicher, der Auswerteeinheit ausgewertet wird, die eine Anzeige zum Anzeigen eines Netzfehlers ansteuert.

Von Vorteil ist dabei, dass ein sicheres und schnelles Abschalten des Antriebs bei erkanntem Netzfehler ausführbar ist. Somit ist die Sicherheit erhöht. Denn mittels des Zählers und der vor dem Rücksetzen erreichbaren Zählerstände ist die Zeitdauer zwischen nächstbenachbarten Nulldurchgängen bestimmbar und somit ein Ausfall einer Netzphase sofort bestimmbar. Auch bei Ausfall des gesamten Netzes ist ein sicheres Abschalten des Netzes sofort ausführbar.

Bei einer vorteilhaften Ausgestaltung werden die mittels Spannungsteiler herabgeteilten Netzphasenspannungen einem dreiphasigen Gleichrichter zugeführt,
wobei die vom Gleichrichter zur Verfügung gestellte Gleichspannung die Komparatoren und das logische Verknüpfungsmittel versorgt,
insbesondere wobei der Gleichrichter drei Dioden-Halbbrücken aufweist,
insbesondere wobei in dem jeweiligen oberen Zweig der jeweiligen Halbbrücke eine Schottky-Diode und in dem jeweiligen unteren Zweig der jeweiligen Halbbrücke eine ZenerDiode angeordnet ist. Von Vorteil ist dabei, dass der Gleichrichter eine Versorgungsspannung zur Verfügung stellt, die mittels der Zenerdioden begrenzbar ist.

**Erfindungsgemäß** sind die Komparatoren als invertierende oder nicht invertierende Schmitt-Trigger ausgeführt. Von Vorteil ist dabei, dass eine einfache Ausführung ermöglicht ist und eine Hysterese berücksichtigbar ist, insbesondere zur Unterdrückung von Instabilitäten.

Bei einer vorteilhaften Ausgestaltung ODER-verknüpft das logische Verknüpfungsmittel die Ausgangssignale der Komparatoren oder die differenzierten Ausgangssignale der Komparatoren. Von Vorteil ist dabei, dass ein einfaches logisches Verknüpfen ermöglicht ist, um ein Ausgangssignal zu erzeugen, das die Bestimmung der Zeitdauern zwischen nächstbenachbarten Nulldurchgängen beziehungsweise den zugehörigen Pulsen bestimmbar macht.

Bei einer vorteilhaften Ausgestaltung wird das Ausgangssignal des logischen Verknüpfungsmittels einem Optokoppler als Eingangssignal zugeführt, dessen galvanisch getrenntes Ausgangssignal einer konfigurierbaren Logikbaustein als Auswerteeinheit zugeführt wird. Von Vorteil ist dabei, dass eine einfach ausführbar galvanische Trennung erreichbar ist.

Bei einer vorteilhaften Ausgestaltung weist die Auswerteeinheit einen Zähler auf, welcher proportional zu einer von einem Taktsignal diskretisierten Zeit, hochzählt, insbesondere inkrementiert wird,
wobei der Zähler vom Ausgangssignal des logischen Verknüpfungsmittels rücksetzbar ist.

Von Vorteil ist dabei, dass eine einfache Bestimmung ermöglicht ist.

Bei einer vorteilhaften Ausgestaltung sind die beim Zurücksetzen auftretenden Zählerstände jeweils in einem Ringspeicher abspeicherbar,
der asynchron zum Zählertakt, insbesondere Taktsignal, auslesbar ist. Von Vorteil ist dabei,
dass in großen Zeitabständen die gespeicherten Zählerstände mit den zugehörigen Zeitstempeln auslesbar und auswertbar sind. Somit ist mit geringer Auslastung des Rechners eine Erkennung von Netzfehlern nebenher, also neben anderen Rechenaufgaben, ausführbar.

Bei einer vorteilhaften Ausgestaltung wird das jeweilige Differenzieren realisiert durch einen jeweiligen Kondensator, welcher jedem invertierenden oder nicht invertierenden Ausgang des jeweiligen Komparators zugeordnet ist,
insbesondere wobei der jeweilige Ausgang eines jeweiligen Komparators mittels des jeweiligen Kondensators verbunden ist mit einem jeweiligen Eingang des logischen Verknüpfungsmittels. Von Vorteil ist dabei, dass aus einer Schaltflanke ein Puls in einfacher Weise herstellbar ist, insbesondere mit einem Kondensator.

Wichtige Merkmale bei dem Verfahren zur Erkennung von Netzfehlern sind, dass die Nulldurchgänge einer jeweiligen Phasenspannung des Wechselspannungsversorgungsnetzes detektiert werden,
ein jeder Phasenspannung zugeordnetes binäres Signal erzeugt wird, mittels jeweiligem Komparator, wobei das Signal von dem jeweiligen Nulldurchgang ausgelöste Pulse oder Schaltflanken aufweist,
wobei die den Phasenspannungen zugeordneten Signale und/oder die invertierten den Phasenspannungen zugeordneten Signale direkt oder differenziert einem logischen Verknüpfungsmittel zugeführt werden, insbesondere einem ODER-Verknüpfungsmittel,
wobei das Ausgangssignal des Verknüpfungsmittels über eine galvanische Trennung, insbesondere über einen Optokoppler, einer Auswerteeinheit zugeführt werden,
wobei das Ausgangssignal des Verknüpfungsmittels zum Rücksetzen eines entsprechend eines Taktsignals hochzählenden Zählers verwendet wird,
wobei die jeweils vor dem Rücksetzen erreichten Zählerstände in einen Ringspeicher eingespeichert werden, der asynchron zum Taktsignal ausgelesen wird, insbesondere in Zeitabständen, die mindestens hundertmal größer als die Periodendauer des Taktsignals ist.

Von Vorteil ist dabei, dass eine erhöhte Sicherheit erreichbar ist, indem die Netzfehler schnell erkennbar sind. Hierzu werden Signale erzeugt, die Pulse aufweisen, welche synchron zu den Nulldurchgängen der Netzphasen sind. Diese Signale sind dabei in einfacher Weise erzeugbar. Da diese Pulse aufweisenden Signale binäre Signale sind, sind sie ebenso einfach auswertbar. Insbesondere müssen die Signale nur logisch verknüpft werden, insbesondere ODER verknüpft werden und das Ausgangssignal, also das Ergebnis der logischen Verknüpfung, wird zum Rücksetzen eines ansonsten stetig hochlaufenden Zählers verwendet. Somit ist der jeweils lokal maximale Zählerstand, also der zuletzt vor dem Rücksetzen erreichte Zählerstand, ein Maß für den Zeitabstand zum nächstbenachbarten Nulldurchgang. Weicht die so bestimmte Zeitdauer von einem Sollwert mehr als zulässiges Maß ab, ist ein Netzfehler erkennbar. Bei Ausfall zweier Phasenspannungen oder des gesamten Netzes läuft der Zähler immer weiter und überschreitet somit dessen Maximalwert, das auf einen Ausfall des Netzes rückschließen lässt.

Weitere Vorteile ergeben sich aus den Unteransprüchen. Die Erfindung ist nicht auf die Merkmalskombination der Ausführungsbeispiele, sondern nur durch die jeweiligen Merkmalskombinationen der unabhängigen Ansprüche beschränkt.

Die Erfindung wird nun anhand von Abbildungen näher erläutert:

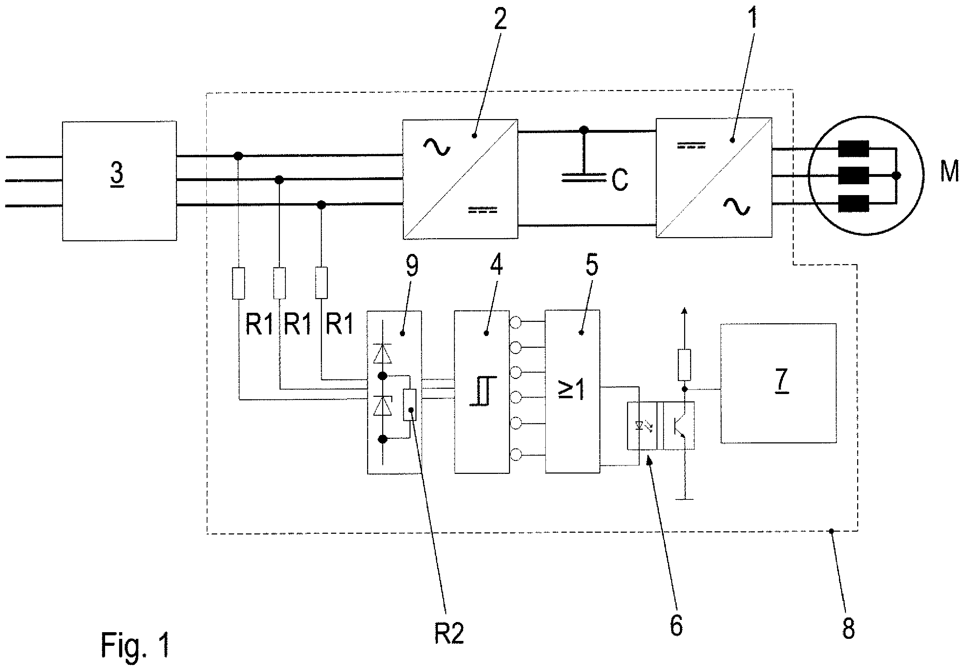

In der Figur 1 ist eine Anordnung zur Netzausfallüberwachung schematisch dargestellt.
In der Figur 2 ist das zugehörige Arbeitsverfahren schematisch dargestellt.
In der Figur 3 ist der Verlauf eines Zählersignals näher dargestellt.

Wie in den Figuren gezeigt, weist der Umrichter einen aus einem Wechselspannungsversorgungsnetz über Netzfilter 3 versorgten Gleichrichter 2 auf, an dessen gleichspannungsseitigem Anschluss ein Kondensator, also Zwischenkreiskondensator C, angeordnet ist zur Glättung der Spannung. Außerdem ist der gleichspannungsseitige Anschluss eines Wechselrichters 1 mit dem gleichspannungsseitigen Anschluss des Gleichrichters 2 verbunden, wobei der Wechselrichter 1 einen Elektromotor M speist.

Das Wechselspannungsversorgungsnetz ist dreiphasig ausgeführt. An jeder der Phasen dieses Wechselspannungsversorgungsnetzes ist ein erster Anschluss einer Reihenschaltung von Widerständen (R1, R2) verbunden, wobei die jeweiligen anderen Anschlüsse der Reihenschaltungen miteinander verbunden sind. Somit sind die drei Reihenschaltungen sternförmig angeordnet und der Sternpunkt bildet ein Bezugspotential. Vorzugsweise besteht jede der Reihenschaltungen aus einem oberen Widerstand R1 und einem unteren Widerstand R2. Dabei wird die an den unteren Widerständen R2 abfallenden Spannungen einerseits dem wechselspannungsseitigen Eingang eines drei Halbbrücken aufweisenden Gleichrichters zugeführt, um eine Versorgungsgleichspannung zu bilden, welche weitere Baugruppen einer Signalelektronik versorgt, die einen Komparator 4, ein logisches Verknüpfungsmittel 5, insbesondere ODER-Verknüpfungsmittel, und eine Auswerteeinheit 7 aufweist.

Andererseits werden die an den unteren Widerständen abfallenden Spannungen auch einem jeweiligen Komparator 4 zugeführt, der als Schmitt-Trigger ausführbar ist.

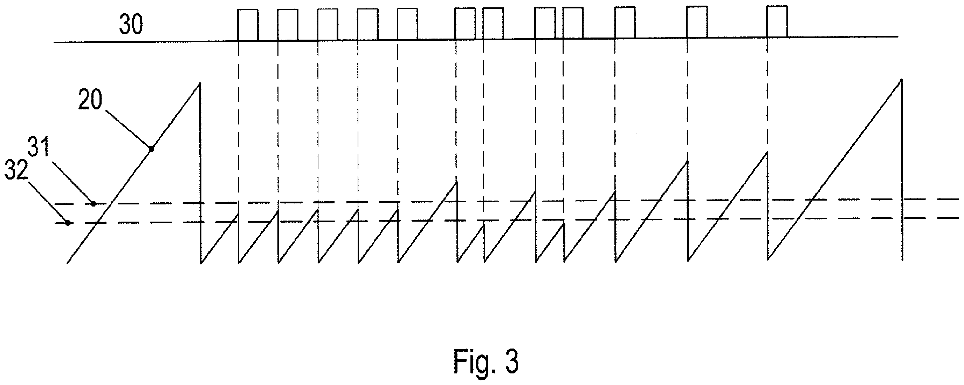

Somit werden bei den Nulldurchgängen der Phasenspannungen des Wechselspannungsversorgungsnetzes Pulsflanken erzeugt, also Zustandswechsel eines jeweiligen Binärsignals. Die so von den jeweiligen Phasenspannungen zugeordneten Komparatoren 5 erzeugten Binärsignale werden dem logischen Verknüpfungsmittel 5, insbesondere ODER-Verknüpfungsmittel, zugeführt. Das Ausgangssignal wird zum Rücksetzen eines ansonsten proportional zur Systemzeit hochzählenden Zählers verwendet. Das Ausgangssignal 20 des Zählers ist hierbei in Figur 3 beispielhaft dargestellt.

Wie in Figur 3 gezeigt, wird bei Überschreiten eines oberen Schwellwertes 32 ein Netzausfall erkannt. Bei Unterschreiten eines unteren Schwellwertes 31 ist ein Netz-Fehler vorhanden.

Der untere Schwellwert 31 ist betragsmäßig kleiner als der obere Schwellwert 32.

Nur wenn die Rücksetzung des Zählerstandsignals, also das Ausgangssignal 20 des Zählers, zwischen dem oberen Schwellwert 32 und dem unteren Schwellwert 31 liegt, ist das Wechselspannungsversorgungsnetz fehlerfrei, also ohne Ausfall einer Phasenspannung und ohne kritischem Unterspannungsniveau.

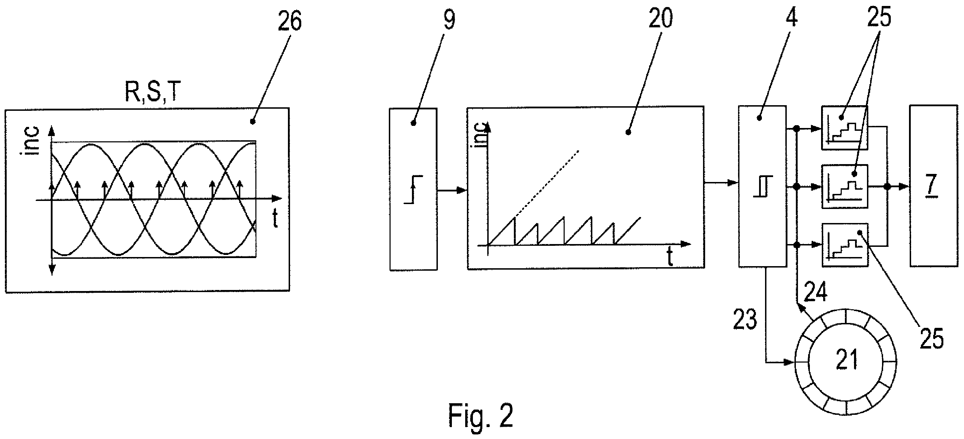

Wie in Figur 2 dargestellt, werden die erreichten Spitzenwerte der Zählerstände in einen Ringspeicher 25 eingelesen, also abgespeichert 23, so dass ein sehr schnelles Abspeichern von Daten ermöglichst ist.

Das Auslesen des Ringspeichers 25 erfolgt asynchron zur Taktfrequenz des Zählers. Die ausgelesenen Daten werden der Auswerteeinheit 7 zugeführt und entsprechende Fehlersignale oder Warnsignale erzeugt, weitergeleitet und/oder angezeigt.

Zwischen den oberen Widerständen R1 der Reihenschaltungen und dem Wechselspannungsversorgungsnetz ist das Netzfilter 3 angeordnet.

Die Eingangssignale für die Auswerteeinheit 7 werden ihr über Optokoppler als galvanische Trennmittel 6 zugeführt.

Bei einem weiteren erfindungsgemäßen Ausführungsbeispiel ist das Netzfilter 3 im Umrichter 8 integriert, also innerhalb des Gehäuses des Umrichters 8 angeordnet.

Bei einem weiteren erfindungsgemäßen Ausführungsbeispiel ist der Gleichrichter 9 derart aufgebaut, dass in den drei Halbbrücken in den oberen Zweigen Schottky-Dioden und in den unteren Zweigen Zenerdioden angeordnet sind. Mittels der Zenerdioden ist somit eine Spannungsbegrenzung des Weitspannungsbereichs für die Auswerteeinheit erreichbar.

Bevorzugt liefert die Schaltung also bei vorhandenem Wechselspannungsversorgungsnetz ein Pulssignal, welches mit der sechsfachen Netzfrequenz pulsiert. Bei einem Netzausfall hört das Pulsen auf - unabhängig von der Netzspannung. Bei einem Phasenausfall fehlt bei der jeweils ausgefallenen Phase das zugehörige Komparatorsignal des als Pulsformer arbeitenden Schmitt-Triggers. Fallen zwei Netzphasen aus, fällt das Pulsen ebenfalls komplett weg, so dass dieser Fehlerzustand von einem vollständigen Netzausfall nicht zu unterscheiden ist.

Die Netzspannung wird vor der Einweggleichrichtung der jeweiligen Netzphase mit den in Reihe geschalteten hochohmigen Vorwiderständen (R1, R2) heruntergeteilt. Die Spannungsversorgung erfolgt also mit einer Einweggleichrichtung, bestehend aus einer Reihenschaltung aus der Schottky-Diode und der Zenerdiode, für jede Netzphase.

Die Zenerdiode begrenzt dabei die Versorgungsspannung auf den maximalen Weitspannungsbereich der nachfolgenden invertierenden, also Pulsformer arbeitenden Schmitt-Trigger.

Die Auswerteschaltung benötigt kein separates Netzteil zur Spannungsversorgung, sondern versorgt sich autark aus der vorhandenen Netzspannung sofern mindestens zwei der drei Netzphasen vorhanden sind.

Die Netzphasenspannungen werden dabei für jede einzelne Netzphase auf deren Nulldurchgänge der Sinushalbwellen überwacht. Die Überwachung erfolgt mit jeweils sechs Schmitt-Triggern, welche die drei verketteten Spannungen mit den Schwellwerten der Schmitt-Trigger vergleichen. Zur Detektion der Nulldurchgänge werden die Eingänge durch ein RC-Filter gefiltert, welche gleichzeitig eine Grundlast für die eingangsseitige hochohmige Widerstandskette darstellt.

Die Eingänge der als Pulsformer arbeitenden Schmitt-Trigger werden durch den hochohmigen Widerstand gegen kurzzeitige Überspannungen geschützt. Diese Überspannungen werden dadurch über die HIGH-Side Schottky-Dioden abgeführt und nicht durch die interne Body-Diode der Pulsformer.

Durch die Rückkopplung der Pulsformer werden sowohl positive als auch negative Nulldurchgänge der Netzspannungen detektiert. Die Pulslänge, die am Ausgang während der Nulldurchgänge entsteht, leitet sich aus der am Ausgang der Pulsformer geschalteten Kapazität und den internen Vorwiderständen der NPN-Transistoren, welche für eine charakteristische Zeitdauer die Diode des jeweiligen Optokopplers einschalten, welcher das Pulssignal für die Auswertung bereitstellt. Die Transistoren sind als ODER-Verknüpfungsmittel geschaltet.

Die Auswerteeinheit ist vorzugsweise als konfigurierbarer Logikbaustein, wie FPGA, ausführbar.

### Bezugszeichenliste

1 Wechselrichter
2 Gleichrichter
3 Netzfilter
4 Komparator, insbesondere Schmitt-Trigger
5 logisches Verknüpfungsmittel, insbesondere ODER-Verknüpfungsmittel
6 galvanisches Trennmittel, insbesondere Optokoppler
7 Auswerteeinheit
8 Umrichter
9 Gleichrichter mit Nulldurchgangspulsbildner
20 Zählersignal
23 Abspeichern von Daten
24 Auslesen der Daten
25 Ringspeicher
26 Verlauf der Phasenspannungen des versorgenden Wechselspannungsnetzes.
30 Nulldurchgangspulse
31 erster Schwellwert
32 zweiter Schwellwert
R1 Widerstand
R2 Widerstand
C Zwischenkreiskondensator
M Elektromotor, insbesondere Drehstrommotor

## Patentansprüche

1. Antriebssystem mit einer Anordnung zur Erkennung von Netzfehlern,
**dadurch gekennzeichnet, dass**
**das Antriebssystem**
- **einen Umrichter, aufweisend einen Wechselrichter** (1) **und einen aus einem Wechselspannungsversorgungnetz insbesondere über ein Netzfilter (3) versorgbaren Gleichrichter (2),**
- **einen** Elektromotor (M),
- **eine Auswerteeinheit (7) mit einem** entsprechend einem Taktsignals **hochzählenden Zähler und mit einem Speicher, insbesondere Ringspeicher (25),**
- **Komparatoren (4) und**
- **ein logisches Verknüpfungsmittel (5)**
**aufweist,**
**wobei aus dem gleichspannungsseitigen Anschluss des Gleichrichters (2) der gleichspannungsseitige Anschluss des Wechselrichters des Umrichters versorgbar ist, wobei der Elektromotor vom Wechselrichter speisbar ist,**
**wobei** jeder Phasenspannung des Wechselspannungsversorgungsnetzes **einer der Komparatoren** (4) zugeordnet ist,
wobei die Ausgangssignale der Komparatoren (4) **d**em logischen Verknüpfungsmittel (5) zugeführt werden, dessen Ausgangssignal **galvanisch getrennt d**er Auswerteeinheit (7) zugeführt wird,
wobei der jeweilige Komparator (4) ein Ausgangssignal erzeugt, das zu den Nulldurchgängen der jeweiligen Phasenspannung des Wechselspannungsversorgungsnetzes synchrone Pulse aufweist und dem logischen Verknüpfungsmittel (5) zugeführt wird,
wobei **das Antriebssystem derart eingerichtet ist, dass** das Ausgangssignal des logischen Verknüpfungsmittels (5) dem Rücksetzeingang **des Zählers** zugeführt wird,
wobei **die Auswerteeinheit (7) derart eingerichtet ist, dass** der beim jeweiligen Rücksetzen des Zählers vorhandene Zählerstand in dem Speicher, insbesondere Ringspeicher (25), der Auswerteeinheit (7) ausgewertet wird, die eine Anzeige zum Anzeigen eines Netzfehlers ansteuert,
**wobei die Komparatoren (4) als invertierende oder nicht invertierende Schmitt-Trigger ausgeführt sind.**

2. Antriebssystem nach **Anspruch 1,**
**dadurch gekennzeichnet, dass**
die mittels Spannungsteiler herabgeteilten Netzphasenspannungen einem zweiten, dreiphasigen Gleichrichter (9) zugeführt werden,
wobei die vom zweiten Gleichrichter (9) zur Verfügung gestellte Gleichspannung die Komparatoren (4) und das logische Verknüpfungsmittel (5) versorgt,
insbesondere wobei der zweite Gleichrichter (9) drei Dioden-Halbbrücken aufweist,
insbesondere wobei in dem jeweiligen oberen Zweig der jeweiligen Halbbrücke eine Schottky-Diode und in dem jeweiligen unteren Zweig der jeweiligen Halbbrücke eine ZenerDiode angeordnet ist.

3. Antriebssystem nach mindestens einem der vorangegangenen Ansprüche,
**dadurch gekennzeichnet, dass**
das logische Verknüpfungsmittel (5) die Ausgangssignale der Komparatoren (4) ODER-verknüpft oder die differenzierten Ausgangssignale der Komparatoren (4) ODER-verknüpft.

4. Antriebssystem nach mindestens einem der vorangegangenen Ansprüche,
**dadurch gekennzeichnet, dass**
das Ausgangssignal des logischen Verknüpfungsmittels (5) einem Optokoppler als Eingangssignal zugeführt wird, dessen galvanisch getrenntes Ausgangssignal einem konfigurierbaren Logikbaustein als Auswerteeinheit (7) zugeführt wird.

5. Antriebssystem nach mindestens einem der vorangegangenen Ansprüche,
**dadurch gekennzeichnet, dass**
die Auswerteeinheit (7) den Zähler aufweist, welcher entsprechend eines Taktsignals, insbesondere proportional zur einer von einem Taktsignal diskretisierten Zeit, hochzählt, insbesondere inkrementiert wird,
wobei der Zähler vom Ausgangssignal des logischen Verknüpfungsmittels (5) rücksetzbar ist.

6. Antriebssystem nach mindestens einem der vorangegangenen Ansprüche,
**dadurch gekennzeichnet, dass**
die beim Zurücksetzen auftretenden Zählerstände jeweils in einem Ringspeicher (25) abspeicherbar sind,
der asynchron zum Zählertakt, insbesondere Taktsignal, auslesbar ist.

7. **Antriebssystem nach einem der Ansprüche 3 bis 6,**
**dadurch gekennzeichnet, dass**
das jeweilige Differenzieren realisiert wird durch einen jeweiligen Kondensator, welcher jedem invertierenden oder nicht invertierenden Ausgang des jeweiligen Komparators (4) zugeordnet ist,
insbesondere wobei der jeweilige Ausgang eines jeweiligen Komparators (4) mittels des jeweiligen Kondensators verbunden ist mit einem jeweiligen Eingang des logischen Verknüpfungsmittels (5).

8. Verfahren zur Erkennung von Netzfehlern **bei einem Antriebssystem nach mindestens einem der vorangegangenen Ansprüche,**
**dadurch gekennzeichnet, dass**
die Nulldurchgänge einer jeweiligen Phasenspannung des Wechselspannungsversorgungsnetzes detektiert werden,
ein jeder Phasenspannung zugeordnetes binäres Signal erzeugt wird mittels jeweiligem Komparator (4), wobei das Signal von dem jeweiligen Nulldurchgang ausgelöste Pulse oder Schaltflanken aufweist,
**wobei die Komparatoren (4) als invertierende oder nicht invertierende Schmitt-Trigger ausgeführt** sind,
wobei die den Phasenspannungen zugeordneten Signale und/oder die invertierten den Phasenspannungen zugeordneten Signale direkt oder differenziert einem logischen **ODER-**Verknüpfungsmittel (5) zugeführt werden,
wobei das Ausgangssignal des Verknüpfungsmittels (5) über eine galvanische Trennung, insbesondere über einen Optokoppler, der Auswerteeinheit (7) zugeführt wird,
wobei das Ausgangssignal des Verknüpfungsmittels (5) zum Rücksetzen des entsprechend eines Taktsignals hochzählenden Zählers verwendet wird,
wobei die jeweils vor dem Rücksetzen erreichten Zählerstände in den Ringspeicher (25) gespeichert werden, der asynchron zum Taktsignal ausgelesen wird, insbesondere in Zeitabständen, die größer als die Periodendauer des Taktsignals ist, insbesondere die mindestens hundertmal größer als die Periodendauer des Taktsignals ist.

## Claims

1. Drive system comprising an arrangement for identifying grid faults,
**characterised in that**
the drive system has
- a converter having an inverter (1) and a rectifier (2), which can be powered from an AC voltage supply grid, in particular by means of a grid filter (3),
- an electric motor (M),
- an evaluation unit (7) comprising a counter, which is incremented in accordance with a clock signal, and a memory, in particular a circular buffer (25),
- comparators (4) and
- a logical gating means (5),
wherein the DC voltage-side terminal of the inverter of the converter can be powered from the DC voltage-side terminal of the rectifier (2), wherein the electric motor can be fed by the inverter,
wherein each phase voltage of the AC voltage supply grid is assigned one of the comparators (4),
wherein the output signals of the comparators (4) are supplied to the logical gating means (5), the output signal of which is supplied to the evaluation unit (7) in a galvanically isolated manner,
wherein each comparator (4) generates an output signal, which has synchronous pulses with respect to the zero crossings of each phase voltage of the AC voltage supply grid and is supplied to the logical gating means (5),
wherein the drive system is configured such that the output signal of the logical gating means (5) is supplied to the resetting input of the counter,
wherein the evaluation unit (7) is configured such that the counter status present each time the counter is reset is evaluated in the memory, in particular the circular buffer (25), of the evaluation unit (7), which actuates a display for displaying a grid fault,
wherein the comparators (4) are implemented as inverting or non-inverting Schmitt triggers.

2. Drive system according to claim 1,
**characterised in that**
the grid phase voltages divided by means of voltage dividers are supplied to a second, three-phase rectifier (9),
wherein the DC voltage made available by the second rectifier (9) powers the comparators (4) and the logical gating means (5),
in particular wherein the second rectifier (9) has three diode half-bridges,
in particular wherein a Schottky diode is arranged in each upper branch of each half-bridge and a Zener diode is arranged in each lower branch of each half-bridge.

3. Drive system according to at least one of the preceding claims,
**characterised in that**
the logical gating means (5) OR-gates the output signals of the comparators (4) or OR-gates the differentiated output signals of the comparators (4).

4. Drive system according to at least one of the preceding claims,
**characterised in that**
the output signal of the logical gating means (5) is supplied as an input signal to an optocoupler, the galvanically isolated output signal of which is fed to a configurable logic module as the evaluation unit (7).

5. Drive system according to at least one of the preceding claims,
**characterised in that**
the evaluation unit (7) has a counter that is incremented, in particular increased, in accordance with a clock signal, in particular in proportion to a time quantised by a clock signal,
wherein the counter can be reset by the output signal of the logical gating means (5).

6. Drive system according to at least one of the preceding claims,
**characterised in that**
the counter statuses that occur upon resetting can each be stored in a circular buffer (25), which can be read out asynchronously with the counter clock, in particular the clock signal.

7. Drive system according to any of claims 3 to 6,
**characterised in that**
each differentiation is carried out by a respective capacitor assigned to each inverting or non-inverting output of each comparator (4),
in particular wherein the relevant output of each comparator (4) is connected to a respective input of the logical gating means (5) by means of the respective capacitor.

8. Method for identifying grid faults in a drive system according to at least one of the preceding claims,
**characterised in that**
the zero crossings of each phase voltage of the AC voltage supply grid are detected, a binary signal assigned to each phase voltage is generated by means of a respective comparator (4), wherein the signal has pulses or switching edges triggered by each zero crossing,
wherein the comparators (4) are implemented as inverting or non-inverting Schmitt triggers, wherein the signals assigned to the phase voltages and/or the inverted signals assigned to the phase voltages are supplied to a logical OR-gating means (5) either directly or in a differentiated manner,
wherein the output signal of the gating means (5) is supplied to the evaluation unit (7) by means of a galvanic isolation, in particular by means of an optocoupler,
wherein the output signal of the gating means (5) is used to reset the counter, which is incremented in accordance with a clock signal,
wherein the counter statuses achieved before each resetting are stored in the circular buffer (25), which is read out asynchronously with the clock signal, in particular at intervals that are greater than the period duration of the clock signal, in particular that are at least one hundred times greater than the period duration of the clock signal.

## Revendications

1. Système d'entraînement équipé d'un dispositif d'identification de défaillances de réseau,
**caractérisé par le fait que**
ledit système d'entraînement comprend
- un convertisseur muni d'un onduleur (1) et d'un redresseur (2) pouvant être alimenté à partir d'un réseau d'alimentation en tension alternative, notamment par l'intermédiaire d'un filtre de réseau (3),
- un moteur électrique (M),
- une unité d'évaluation (7) dotée d'un compteur à comptage croissant en concordance avec un signal d'horloge, et d'une mémoire, en particulier une mémoire (25) en anneau,
- des comparateurs (4) et
- un moyen (5) de combinaison logique,
sachant que la connexion de l'onduleur du convertisseur, située côte tension continue, peut être alimentée à partir de la connexion du redresseur (2) située côte tension continue, le moteur électrique pouvant être alimenté par ledit onduleur,
sachant que l'un des comparateurs (4) est affecté à chaque tension de phase du réseau d'alimentation en tension alternative,
les signaux de sortie desdits comparateurs (4) étant délivrés au moyen (5) de combinaison logique, dont le signal de sortie est délivré à l'unité d'évaluation (7) avec isolation galvanique,
sachant que le comparateur (4) considéré engendre un signal de sortie qui présente des impulsions synchrones avec les passages par zéro de la tension de phase respective dudit réseau d'alimentation en tension alternative, et est délivré audit moyen (5) de combinaison logique,
ledit système d'entraînement étant agencé de telle sorte que le signal de sortie dudit moyen (5) de combinaison logique soit délivré à l'entrée de réinitialisation du compteur,
l'unité d'évaluation (7) étant agencée de façon telle que l'état de comptage, présent lors de la réinitialisation respective dudit compteur, soit évalué dans la mémoire, notamment la mémoire (25) en anneau de ladite unité d'évaluation (7), laquelle pilote un affichage dévolu à la visualisation d'une défaillance de réseau,
lesdits comparateurs (4) étant réalisés en tant que bascules de Schmitt inverseuses ou non inverseuses.

2. Système d'entraînement selon la revendication 1,
**caractérisé par le fait que**
les tensions de phases du réseau, scindées au moyen de diviseurs de tension, sont appliquées à un second redresseur (9) triphasé,
la tension continue, mise à disposition par ledit second redresseur (9), alimentant alors les comparateurs (4) et le moyen (5) de combinaison logique,
ledit second redresseur (9) étant notamment pourvu de trois demi-ponts à diodes, sachant, en particulier, qu'une diode de Schottky et une diode de Zener sont intégrées, respectivement, dans la branche supérieure respective du demi-pont considéré et dans la branche inférieure respective du demi-pont considéré.

3. Système d'entraînement selon au moins l'une des revendications précédentes,
**caractérisé par le fait que**
le moyen (5) de combinaison logique effectue une combinaison OU des signaux de sortie des comparateurs (4), ou bien une combinaison OU des signaux de sortie différenciés desdits comparateurs (4).

4. Système d'entraînement selon au moins l'une des revendications précédentes,
**caractérisé par le fait que**
le signal de sortie du moyen (5) de combinaison logique est délivré, en tant que signal d'entrée, à un optocoupleur dont le signal de sortie, galvaniquement isolé, est délivré à un module logique pouvant être configuré en tant qu'unité d'évaluation (7).

5. Système d'entraînement selon au moins l'une des revendications précédentes,
**caractérisé par le fait que**
l'unité d'évaluation (7) est munie du compteur qui effectue un comptage croissant en concordance avec un signal d'horloge, en particulier proportionnellement à un temps discrétisé par un signal d'horloge, et est notamment incrémenté,
ledit compteur pouvant être réinitialisé par le signal de sortie du moyen (5) de combinaison logique.

6. Système d'entraînement selon au moins l'une des revendications précédentes,
**caractérisé par le fait que**
les états de comptage, se présentant lors de la réinitialisation, peuvent être respectivement stockés dans une mémoire (25) en anneau
qui peut être lue de manière asynchrone par rapport à la cadence de comptage, notamment au signal d'horloge.

7. Système d'entraînement selon l'une des revendications 3 à 6,
**caractérisé par le fait que**
la différenciation considérée est concrétisée par l'intermédiaire d'un condensateur respectif, affecté à chaque sortie inverseuse ou non inverseuse du comparateur (4) respectif,
sachant notamment que la sortie respective d'un comparateur (4) considéré est raccordée, au moyen dudit condensateur respectif, à une entrée respective du moyen (5) de combinaison logique.

8. Procédé d'identification de défaillances de réseau dans un système d'entraînement conforme à au moins l'une des revendications précédentes,
**caractérisé par le fait que**
les passages par zéro d'une tension de phase considérée du réseau d'alimentation en tension alternative sont détectés,
un signal binaire, affecté à chaque tension de phase, est engendré au moyen d'un comparateur (4) respectif, lequel signal présente des impulsions ou des flancs de commutation déclenché(e)s par le passage par zéro considéré,
sachant que les comparateurs (4) sont réalisés en tant que bascules de Schmitt inverseuses ou non inverseuses,
sachant que les signaux affectés aux tensions de phase et/ou les signaux inversés affectés auxdits tensions de phase sont délivrés, en mode direct ou différencié, à un moyen (5) de combinaison logique OU,
le signal de sortie dudit moyen (5) de combinaison logique étant délivré à l'unité d'évaluation (7) par l'intermédiaire d'une isolation galvanique, en particulier par l'intermédiaire d'un optocoupleur,
lequel signal de sortie dudit moyen (5) de combinaison logique est utilisé pour la réinitialisation du compteur à comptage croissant en concordance avec un signal d'horloge,
sachant que les états de comptage, respectivement atteints avant ladite réinitialisation, sont stockés dans la mémoire (25) en anneau lue de manière asynchrone, par rapport audit signal d'horloge, notamment à des intervalles de temps qui sont supérieurs à la période dudit signal d'horloge et sont, en particulier, au moins cent fois supérieurs à ladite période du signal d'horloge.
